# EUROPEAN PATENT APPLICATION

(11) **EP 3 202 515 A1**
(43) Date of publication of application: **09.08.2017**
(21) Application number: 15845750.7
(22) Date of filing: 29.09.2015
(51) Int. Cl.: B23B 27/14, C23C 16/36

(54) **SURFACE-COATED CUTTING TOOL HAVING EXCELLENT CHIP RESISTANCE**

(30) Priority: 30.09.2014 JP 2014200000; 16.09.2015 JP 2015182740
(71) Applicant: Mitsubishi Materials Corporation, Chiyoda-ku Tokyo 100-8117 (JP)
(72) Inventor: SATO Kenichi, Naka-shi Ibaraki 311-0102 (JP); TATSUOKA Sho, Naka-shi Ibaraki 311-0102 (JP); YAMAGUCHI Kenji, Naka-shi Ibaraki 311-0102 (JP)
(74) Representative: Gille Hrabal
(86) International application number: PCT/JP2015/077457
(87) International publication number: WO 2016/052479

(57) **Abstract**

Provided is a surface-coated cutting tool in which a hard coating layer exhibits chipping resistance and peeling resistance under high-speed intermittent heavy cutting conditions. In the surface-coated cutting tool in which the surface of a tool body is coated with a lower layer including a TiCN layer having at least an NaCl type face-centered cubic crystal structure and an upper layer formed of a TiAlCN layer having a single phase crystal structure of NaCl type face-centered cubic crystals or a mixed phase crystal structure of NaCl type face-centered cubic crystals and hexagonal crystals, and is preferably further coated with an outermost surface layer including an Al₂O₃ layer, when the layer of a complex nitride or complex carbonitride of Ti and Al is expressed by the composition formula: (Ti₁₋ₓAlₓ) (C_{y}N_{1-y}), the average amount Xave of Al in the total amount of Ti and Al and the average amount Yave of C in the total amount of C and N (both Xave and Yave are atomic ratios) respectively satisfy 0.60 ≤ Xave ≤ 0.95 and 0 ≤ Yave ≤ 0.005.

## Description

### Technical Field

The present invention relates to a surface-coated cutting tool (hereinafter, referred to as coated tool), in which a hard coating layer exhibits excellent chipping resistance even in a case where cutting of various steels, cast iron, or the like is performed under high-speed intermittent heavy cutting conditions at high speed with intermittent and impact loads exerted on a cutting edge, and thus exhibits excellent cutting performance during long-term use.

### Background Art

Hitherto, in general, there is known a coated tool which is deposited, on the surface of a body made of tungsten carbide (hereinafter, referred to as WC)-based cemented carbide or titanium carbonitride (hereinafter, referred to as TiCN)-based cermet (hereinafter, collectively referred to as a tool body),
a hard coating layer constituted by (a) and (b), that is,
(a) a lower layer which is a Ti compound layer that is formed of one layer or two or more layers of a Ti carbide (hereinafter, referred to as TiC) layer, a Ti nitride (hereinafter, similarly referred to as TiN) layer, a Ti carbonitride (hereinafter, referred to as TiCN) layer, a Ti oxycarbide (hereinafter, referred to as TiCO) layer, and a Ti oxycarbonitride (hereinafter, referred to as TiCNO) layer, and
(b) an upper layer which is an aluminum oxide layer (hereinafter, referred to as Al₂O₃ layer) having an α type crystal structure in a chemically deposited state.

The coated tool in the related art described above exhibits excellent wear resistance, for example, during continuous cutting or intermittent cutting of various steels, cast iron, or the like. However, in a case where the coated tool is used during high-speed intermittent cutting, there are problems in that peeling or chipping of the hard coating layer easily occurs and the service life of the tool shortens.

Here, various coated tools in which an improvement in an upper layer is achieved in order to suppress peeling and chipping of a hard coating layer have been suggested.

For example, PTL 1 suggests a coated tool which is an alumina-coated tool in which a non-oxide film made of one or more of carbides, nitrides, and carbonitrides of the metals in Groups 4a, 5a, and 6a in the periodic table is formed on the surface of a tool body, and an oxide film primarily containing α-Al₂O₃ is formed thereon, a bonding layer having an fcc structure formed of a single-layer film or multi-layer film based on an oxide such as oxides, oxycarbides, oxynitrides, and oxycarbonitrides of the metals in Groups 4a, 5a, and 6a in the periodic table is formed between the non-oxide film and the oxide film, and the non-oxide film and the bonding phase have an epitaxial relationship, whereby the adhesion strength between the tool body and the alumina film is increased, resulting by improving fracture resistance, peeling resistance, and wear resistance.

In addition, for example, PTL 2 suggests a surface-coated cutting tool in which a Ti compound layer as a lower layer, which is formed of at least one layer of TiN, TiC, TiCN, TiCO, and TiCNO, and a Al₂O₃ layer as an upper layer are deposited on the surface of a tool body, and by forming TiO₂ fine grains having a grain size of 10 nm to 100 nm at the interface between the lower layer and the upper layer and causing the line segment ratio of the TiO₂ fine grains per 10 µm of the length of the interface to be 10% to 50%, the aluminum oxide crystal grains of the upper layer are non-epitaxially grown on the TiO₂ grains with respect to the lower layer and are epitaxially grown on the interface where the TiO₂ grains are absent with respect to the lower layer, whereby the chipping resistance and wear resistance of a hard coating layer are improved.

### Citation List

### Patent Literature

[PTL 1] JP-A-10-18039
[PTL 2] JP-A-2010-201575

### Summary of Invention

### Technical Problem

There has been a remarkable improvement in the performance of cutting devices in recent years, and there has also been a strong demand for power saving and energy saving and a further reduction in costs during cutting. In accordance with this, there is a trend toward a further increase in speed during cutting and an increase in impact and intermittent loads exerted on a cutting edge during intermittent heavy cutting with a large depth of cut and a high feed rate. There is no problem in a case where the coated tool in the related art described above is used for continuous cutting or intermittent cutting of steel, cast iron, or the like under typical conditions. However, in a case where the coated tool is used under high-speed intermittent heavy cutting conditions, cracks initiated at the surface of a hard coating layer are likely to propagate to the entire hard coating layer, and the end of the service life is reached within a relatively short time in current situations.

### Solution to Problem

Here, from the above-described viewpoint, the inventors focused on controlling an epitaxial relationship between crystal grains of a Ti compound constituting a lower layer formed on the surface of a tool body and crystal grains of a complex nitride or complex carbonitride of Ti and Al (hereinafter, abbreviated to TiAlCN) constituting an upper layer formed thereon, and intensively studied.

As a result, knowledge that regarding crystal grains including the crystal grains of the Ti carbonitride (TiCN) layer having an NaCl type face-centered cubic crystal structure constituting at least one layer of the lower layer and the crystal grains of the TiAlCN layer constituting the upper layer, by causing the formation proportion of crystal grains which have a difference in orientation between the crystal orientation of the TiCN crystal grains and the crystal orientation of the TiAlCN crystal grains of 5 degrees or lower and are thus epitaxially grown through the interface between the TiCN layer and the TiAlCN layer to be a predetermined value, the adhesion strength of the interface between the TiCN layer and the TiAlCN layer is improved, and as a result, even under high-speed intermittent heavy cutting conditions in which high intermittent and impact loads are exerted on a cutting edge at a high speed, the hard coating layer exhibits excellent chipping resistance and peeling resistance, was obtained.

The present invention is made based on the above-described knowledge and is characterized by including
"(1) a surface-coated cutting tool in which a hard coating layer constituted by a lower layer and an upper layer is formed on a surface of a tool body made of any of tungsten carbide-based cemented carbide, titanium carbonitride-based cermet, and a cubic boron nitride-based ultrahigh-pressure sintered body, in which
   (a) the lower layer is a Ti compound layer that is formed of one layer or two or more layers of a Ti carbide layer, a Ti nitride layer, a Ti carbonitride layer, a Ti oxycarbide layer, and a Ti oxycarbonitride layer and has a total average layer thickness of 1 µm to 20 µm, and includes a Ti carbonitride compound layer having at least an NaCl type face-centered cubic crystal structure,
   (b) the upper layer is a layer of a complex nitride or complex carbonitride of Ti and Al having a single phase crystal structure of NaCl type face-centered cubic crystals or a mixed phase crystal structure of NaCl type face-centered cubic crystals and hexagonal crystals with an average layer thickness of 1 µm to 20 µm,
   (c) in a case where the layer of a complex nitride or complex carbonitride of Ti and Al is expressed by the composition formula: (Ti₁₋ₓAlₓ) (C_{y}N_{1-y}), an average amount Xave of Al in a total amount of Ti and Al and an average amount Yave of C in a total amount of C and N (both Xave and Yave are atomic ratios) respectively satisfy 0.60 ≤ Xave ≤ 0.95 and 0 ≤ Yave ≤ 0.005, and
   (d) regarding the Ti carbonitride layer having an NaCl type face-centered cubic crystal structure in the lower layer and the layer of a complex nitride or complex carbonitride of Ti and Al having an NaCl type face-centered cubic crystal structure in the upper layer, in a case where crystal orientations of individual crystal grains are analyzed in a longitudinal sectional direction perpendicular to the tool body using an electron backscatter diffraction apparatus and inclined angles of normal lines of crystal planes of the individual crystal grains with respect to a normal line of the surface of the body are measured, crystal grains, which are crystal grains adjacent to each other via an interface between the upper layer and lower layer and have a difference in orientation between a normal direction of an (hkl) plane of the crystal grains having an NaCl type face-centered cubic crystal structure in the lower layer and a normal direction of an (hkl) plane of the crystal grains having an NaCl type face-centered cubic crystal structure in the upper layer of 5 degrees or lower, are present at the interface between the upper layer and the lower layer, and a linear density of the crystal grains is 2 crystal grains/10 µm or more.
(2) The surface-coated cutting tool described in (1), in which, regarding the Ti carbonitride layer having an NaCl type face-centered cubic crystal structure in the lower layer and the layer of a complex nitride or complex carbonitride of Ti and Al having an NaCl type face-centered cubic crystal structure in the upper layer, in a case where the crystal orientations of the individual crystal grains are analyzed in the longitudinal sectional direction perpendicular to the tool body using the electron backscatter diffraction apparatus and the inclined angles of the normal lines of the crystal planes of the individual crystal grains with respect to the normal line of the surface of the body are measured, an area ratio of the crystal grains, which are the crystal grains adjacent to each other via the interface between the upper layer and lower layer and have a difference in orientation between the normal direction of the (hkl) plane of the crystal grains having an NaCl type face-centered cubic crystal structure in the lower layer and the normal direction of the (hkl) plane of the crystal grains having an NaCl type face-centered cubic crystal structure in the upper layer of 5 degrees or lower, in the Ti carbonitride layer having an NaCl type face-centered cubic crystal structure in the upper layer and the lower layer to a total area of the crystal grains adjacent to each other via the interface between the upper layer and the lower layer is 30% by area or more.
(3) The surface-coated cutting tool described in (1) or (2), in which, regarding the layer of a complex nitride or complex carbonitride of Ti and Al, in a case where the layer is observed in the longitudinal sectional direction, a columnar structure in which the crystal grains of the complex nitride or complex carbonitride of Ti and Al having an NaCl type face-centered cubic structure in the layer have an average grain width W of 0.1 µm to 2.0 µm and an average aspect ratio A of 2 to 10 is included.
(4) The surface-coated cutting tool described in any one of (1) to (3), in which, a surface of the upper layer formed of the layer of a complex nitride or complex carbonitride of Ti and Al having a single phase crystal structure of NaCl type face-centered cubic crystals or a mixed phase crystal structure of NaCl type face-centered cubic crystals and hexagonal crystals with an average layer thickness of 1 µm to 20 µm is further coated with an outermost surface layer which has an average layer thickness of 1 µm to 25 µm and includes at least an Al₂O₃ layer."

Hereinafter, the constituent layers of the hard coating layer of the coated tool of the present invention will be described in detail.

### Lower Layer (Ti Compound Layer):

A Ti compound layer (for example, a Ti carbide (TiC) layer, a Ti nitride (TiN) layer, a Ti carbonitride (TiCN) layer, a Ti oxycarbide (TiCO) layer, or a Ti oxycarbonitride (TiCNO) layer) is basically present as the lower layer of a TiAlCN layer, and due to its excellent high-temperature strength provided by itself, enables the hard coating layer to have high-temperature strength. Moreover, the Ti compound layer adheres to both the tool body and the TiAlCN layer of the upper layer and thus has an action of maintaining adhesion of the hard coating layer to the tool body. However, when the average layer thickness thereof is smaller than 1 µm, the action is insufficiently exhibited. On the other hand, when the average layer thickness thereof is greater than 20 µm, thermoplastic deformation is likely to occur particularly during high-speed heavy cutting and high-speed intermittent cutting accompanied with the generation of high-temperature heat, and this becomes the cause of uneven wear. Accordingly, the average layer thickness thereof is determined to be 1 µm to 20 µm.

Furthermore, in order to cause the upper layer to be epitaxially grown by succeeding the orientation of the lower layer and thus improve the chipping resistance and peeling resistance of the hard coating layer, at least a TiCN layer formed of TiCN crystal grains having an NaCl type face-centered cubic crystal structure needs to be formed in the lower layer.

The lower layer can be formed into an average target layer thickness by chemical vapor deposition using a typical chemical vapor deposition apparatus, for example, under conditions with
a reaction gas composition (% by volume): TiCl₄: 1.0% to 5.0%, N₂: 5% to 35%, CO: 0% to 5%, CH₃CN: 0% to 1%, CH₄: 0% to 10%, and the remainder: H₂,
a reaction atmosphere temperature: 780°C to 900°C, and
a reaction atmosphere pressure: 5 kPa to 13 kPa.

Upper Layer (Layer of Complex Nitride or Complex Carbonitride of Ti and Al Having Single Phase Crystal Structure of NaCl Type Face-Centered Cubic Crystals or Mixed Phase Crystal Structure of NaCl type Face-Centered Cubic Crystals and Hexagonal Crystals):
The upper layer of the hard coating layer of the present invention is formed of a layer of a complex nitride or complex carbonitride of Ti and Al (TiAlCN layer) having a single phase crystal structure of NaCl type face-centered cubic crystals or a mixed phase crystal structure of NaCl type face-centered cubic crystals and hexagonal crystals with an average chemically deposited layer thickness of 1 µm to 20 µm.

The TiAlCN layer included in the upper layer of the present invention has high hardness and exhibits excellent wear resistance. However, when the average layer thickness thereof is smaller than 1 µm, wear resistance during long-term use is insufficiently ensured due to the small layer thickness. On the other hand, when the average layer thickness thereof is greater than 20 µm, the crystal grains coarsen and chipping easily occurs.

Therefore, the average layer thickness of the TiAlCN layer included in the upper layer is determined to be 1 µm to 20 µm.

In a case where the TiAlCN layer included in the upper layer of the present invention is expressed by the composition formula: (Ti₁₋ₓAlₓ) (N_{1-y}C_{y}), the average amount Xave of Al in the total amount of Ti and Al and the amount Yave of C in the total amount of C and N (both Xave and Yave are atomic ratios) respectively satisfy 0.60 ≤ Xave ≤ 0.95 and 0 ≤ Yave ≤ 0.005.

Here, when the average amount Xave (atomic ratio) of Al is less than 0.60, the hardness of the layer of a complex nitride or complex carbonitride of Ti and Al deteriorates. Therefore, in a case of being provided for high-speed intermittent heavy cutting of alloy steel or the like, wear resistance thereof is insufficient. On the other hand, when the average amount Xave of Al is more than 0.95, the amount of Ti is relatively reduced, resulting in embrittlement and a reduction in chipping resistance.

Therefore, the average amount Xave (atomic ratio) of Al is determined to be 0.60 ≤ Xave ≤ 0.95.

In addition, when the average amount (atomic ratio) Yave of the component C contained in the layer of a complex nitride or complex carbonitride is a small amount in a range of 0 ≤ Yave ≤ 0.005, the adhesion between the upper layer and the lower layer is improved. In addition, the lubricity thereof is improved and thus an impact during cutting is relieved, resulting in an improvement in the fracture resistance and chipping resistance of the layer of a complex nitride or complex carbonitride. On the other hand, when the amount Yave of the component C is outside of the range of 0 ≤ Yave ≤ 0.005, the toughness of the layer of a complex nitride or complex carbonitride decreases. Therefore, the fracture resistance and chipping resistance, in contrast, decrease.

Therefore, the amount Yave (atomic ratio) of the component C is determined to be 0 ≤ Yave ≤ 0.005.

Difference in Crystal Plane Orientation between TiCN Crystal Grains Having NaCl Type Face-Centered Cubic Structure in Lower Layer and TiAlCN Crystal Grains Having NaCl Type Face-Centered Cubic Structure in Upper Layer:
Regarding the Ti carbonitride layer having an NaCl type face-centered cubic crystal structure in the lower layer and the layer of a complex nitride or complex carbonitride of Ti and Al having an NaCl type face-centered cubic crystal structure in the upper layer, in a case where the crystal orientations of individual crystal grains are analyzed in a longitudinal sectional direction perpendicular to the tool body using an electron backscatter diffraction apparatus and the inclined angles of the normal lines of the crystal planes of the individual crystal grains with respect to the normal line of the surface of the tool body are measured, the orientations of the crystal grains are determined such that crystal grains, which are crystal grains adjacent to each other via the interface between the upper layer and lower layer and have a difference in orientation between the normal direction of the (hkl) plane of the crystal grains having an NaCl type face-centered cubic crystal structure in the lower layer and the normal direction of the (hkl) plane of the crystal grains having an NaCl type face-centered cubic crystal structure in the upper layer of 5 degrees or lower, are present at the interface between the upper layer and the lower layer, and the linear density of the crystal grains is 2 crystal grains/10 µm or more.

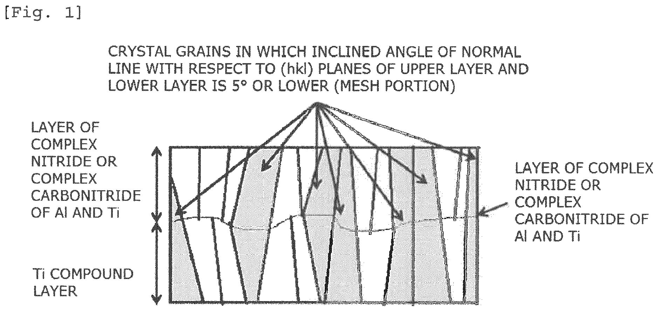

Fig. 1 is a schematic view of the layer structure of the TiCN layer (lower layer) having an NaCl type face-centered cubic crystal structure and the TiAlCN layer (upper layer) having an NaCl type face-centered cubic crystal structure.

As can be seen from Fig. 1, a crystal structure morphology is observed at the interface between the upper layer and the lower layer such that crystal grains are grown through the interface. "Crystal grains adjacent to each other via the interface between the upper layer and lower layer" mentioned in the present invention are crystal grains having such a crystal structure morphology.

In addition, regarding the "crystal grains adjacent to each other via the interface between the upper layer and lower layer", in a case where the inclined angle of the normal direction of an arbitrary crystal plane (hkl) (for example, (112) plane) of the crystal grain having an NaCl type face-centered cubic crystal structure in the lower layer with respect to the normal line of the surface of the tool body is measured, the measured inclined angle is referred to as α(hkl) (degrees), the inclined angle of the normal direction of the (hkl) plane of the crystal grain having an NaCl type face-centered cubic crystal structure in the upper layer with respect to the normal line of the surface of the tool body is measured, and the measured inclined angle is referred to as β(hkl) (degrees), it can be said that the upper layer undergoes crystal growth (epitaxial growth) by succeeding the orientation of the lower layer in a case where the absolute value of the difference between α(hkl) (degrees) and β(hkl) (degrees) is 5 degrees or lower (that is, |α(hkl) - β(hkl)| ≤ 5 (degrees)).

In addition, in a case where the linear density of the crystal grains at the interface between the upper layer and the lower layer which satisfy |α(hkl) - β(hkl)| ≤ 5 (degrees) is exiting 2 crystal grains/10 µm or more, the adhesion strength of the interface between the upper layer and the lower layer is improved. As a result, the chipping resistance and the peeling resistance of the hard coating layer can be increased.

On the other hand, in a case where the linear density of the crystal grains which satisfy |α(hkl) - β(hkl)| ≤ 5 (degrees) is lower than 2 crystal grains/10 µm, it cannot be said that the upper layer has a sufficient epitaxially grown structure over the entire hard coating layer. Therefore, abnormal damage such as chipping and peeling cannot be sufficiently suppressed.

In addition, as the (hkl) plane to be measured, an arbitrary crystal plane may be selected and is not particularly limited. However, for example, by representatively measuring the inclined angle of the normal line of the (100) plane, (110) plane, (111) plane, (211) plane, or (210) plane with respect to the normal line of the surface of the tool body, the difference in plane orientation between the upper layer and the lower layer can be determined.

In addition, the sentence "the linear density is 2 crystal grains/10 µm" described above indicates that the number of crystal grains that satisfy |α(hkl) - β(hkl)| ≤ 5 (degrees) is two or more in a range of a length of 10 µm along the interface between the upper layer and the lower layer.

Area Ratio of Epitaxially Grown Crystal Grains:
In a case where the area ratio of the crystal grains which are crystal grains adjacent to each other via the interface between the upper layer and lower layer, are crystal grains that satisfy the difference in orientation |α(hkl) - β(hkl)| ≤ 5 (degrees) obtained as described above, have a linear density of 2 crystal grains/10 µm or more regarding the crystal grains at the interface between the upper layer and the lower layer, and are epitaxially grown at the same time as described above is 30% or more with respect to the total area of the crystal grains adjacent to each other via the interface between the upper layer and the lower layer (that is, the area of the sum of the crystal grains of the Ti carbonitride layer having an NaCl type face-centered cubic crystal structure in the lower layer and the layer of a complex nitride or complex carbonitride of Ti and Al having an NaCl type face-centered cubic crystal structure in the upper layer, which are adjacent to each other), the hard coating layer having such a crystal structure has further improved chipping resistance and peeling resistance. Therefore, the area ratio of the epitaxially grown crystal grains is preferably 30% or more.

Crystal Grains Having NaCl Type Face-Centered Cubic Structure (hereinafter, sometimes simply referred to as "cubic") Included in Layer of Complex Nitride or Complex Carbonitride:
In a case where each cubic crystal grain in the layer of a complex nitride or complex carbonitride is observed and measured from the film section side which is perpendicular to the surface of the tool body, in a case where the grain width thereof in a direction parallel to the surface of the tool body is referred to as w, the grain length thereof in the direction perpendicular to the surface of the tool body is referred to as 1, the ratio l/w between w and 1 is referred to as the aspect ratio a of each crystal grain, the average value of the aspect ratios a obtained for the individual crystal grains is further referred to as an average aspect ratio A, and the average value of the grain widths w obtained for the individual crystal grains is referred to as an average grain width W, it is preferable that the average grain width W and the average aspect ratio A are controlled to satisfy 0.1 µm to 2.0 µm and 2 to 10, respectively.

When this condition is satisfied, the cubic crystal grains constituting the layer of a complex nitride or complex carbonitride have a columnar structure and exhibit excellent wear resistance. On the other hand, when the average aspect ratio A is lower than 2, a periodic composition distribution, which is a feature of the present invention, is less likely to be formed in the crystal grains having an NaCl type face-centered cubic structure. When a columnar crystal has an average aspect ratio A of higher than 10, cracks are likely to propagate on a plane along a periodic composition distribution in a cubic crystal phase, which is a feature of the present invention, and along a plurality of grain boundaries, which is not preferable. In addition, when the average grain width W is smaller than 0.1 µm, wear resistance decreases. When the average grain width W is greater than 2.0 µm, toughness decreases. Therefore, the average grain width W of the crystal grains constituting the layer of a complex nitride or complex carbonitride is desirably 0.1 µm to 2.0 µm.

### Outermost Surface Layer:

In the present invention, the surface of the upper layer formed of the layer of a complex nitride or complex carbonitride of Ti and Al having a single phase crystal structure of NaCl type face-centered cubic crystals or a mixed phase crystal structure of NaCl type face-centered cubic crystals and hexagonal crystals with an average layer thickness of 1 µm to 20 µm is further coated with an outermost surface layer which has an average layer thickness of 1 µm to 25 µm and includes at least an Al₂O₃ layer.

The Al₂O₃ layer of the outermost surface layer increases the high-temperature hardness and heat resistance of the hard coating layer. However, when the average layer thickness of the outermost surface layer is smaller than 1 µm, the hard coating layer cannot be sufficiently provided with the characteristics. On the other hand, when the average layer thickness thereof is greater than 25 µm, thermoplastic deformation, which is a cause of uneven wear, is likely to occur due to high-temperature heat generated during cutting and high intermittent and impact loads exerted on a cutting edge, resulting in the acceleration of wear. Therefore, the average layer thickness thereof is desirably determined to be 1 µm to 25 µm.

### Film Forming Method:

The lower layer and the outermost surface layer of the present invention can be formed, for example, according to a typical chemical vapor deposition method.

In addition, the upper layer may be formed according to a typical chemical vapor deposition method, but may also be formed, for example, according to the following deposition method.

That is, in a chemical vapor deposition reaction apparatus to which a tool body is mounted, a gas group A of NH₃ and H₂ and a gas group B of TiCl₄, AlCl₃, NH₃, N₂, C₂H₄, and H₂ are supplied into the reaction apparatus from separate gas supply tubes, the composition of a reaction gas on the surface of the tool body is controlled by adjusting supply conditions of the gas group A and the gas group B, and a thermal CVD method is performed at a reaction atmosphere pressure of 2 kPa to 5 kPa and a reaction atmosphere temperature of 700°C to 900°C for a predetermined time, thereby forming a TiAlCN layer having a predetermined target layer thickness and a target composition.

### Advantageous Effects of Invention

In the coated tool of the present invention, TiAlCN crystal grains of the upper layer which have a difference in orientation from the normal direction of the (hkl) plane of TiCN crystal grains of the lower layer of 5 degrees or lower and are thus epitaxially grown are formed on the lower layer having the TiCN layer having an NaCl type face-centered cubic crystal structure, furthermore, the epitaxially grown crystal grains have a linear density of the crystal grains at the interface between the upper layer and the lower layer of 2 crystal grains/10 µm or more, or the area ratio of the epitaxially grown crystal grains is 30% or more with respect to the total area, thereby the adhesion strength between the upper layer and the lower layer is improved. As a result, even under high-speed intermittent heavy cutting conditions in which high intermittent and impact loads are exerted on a cutting edge at a high speed, the hard coating layer exhibits excellent chipping resistance and peeling resistance, and thus exhibits excellent cutting performance during long-term use.

### Brief Description of Drawings

Fig. 1 is a schematic view of the layer structure of a hard coating layer of the present invention including a TiCN layer (lower layer) having an NaCl type face-centered cubic crystal structure and a TiAlCN layer (upper layer) having an NaCl type face-centered cubic crystal structure. Description of Embodiments

Next, a coated tool of the present invention will be described in detail using examples.

### Example 1

As raw material powders, a WC powder, a TiC powder, a TaC powder, an NbC powder, a Cr₃C₂ powder, and a Co powder, all of which had an average grain size of 1 µm to 3 µm, were prepared, and the raw material powders were mixed in mixing compositions shown in Table 1. Wax was further added thereto, and the mixture was blended in acetone by a ball mill for 24 hours and was decompressed and dried. Thereafter, the resultant was press-formed into compacts having predetermined shapes at a pressure of 98 MPa, and the compacts were sintered in a vacuum at 5 Pa under the condition that the compacts were held at a predetermined temperature in a range of 1370°C to 1470°C for one hour. After the sintering, tool bodies A to C made of WC-based cemented carbide with insert shapes according to ISO standard SEEN1203AFSN were produced.

In addition, as raw material powders, a TiCN (TiC/TiN = 50/50 in terms of mass ratio) powder, an Mo₂C powder, a ZrC powder, an NbC powder, a WC powder, a Co powder, and an Ni powder, all of which had an average grain size of 0.5 µm to 2 µm, were prepared, and the raw material powders were mixed in mixing compositions shown in Table 2, were subjected to wet mixing by a ball mill for 24 hours, and were dried. Thereafter, the resultant was press-formed into compacts at a pressure of 98 MPa, and the compacts were sintered in a nitrogen atmosphere at 1.3 kPa under the condition that the compacts were held at a temperature of 1500°C for one hour. After the sintering, a tool body D made of TiCN-based cermet with insert shapes according to ISO standard SEEN1203AFSN was produced.

Next, using a chemical vapor deposition apparatus, present invention coated tools 1 to 13 were produced by forming, on the surfaces of the tool bodies A to D,
first, lower layers shown in Table 6 under forming conditions shown in Table 3, and
subsequently, forming upper layers under forming conditions A to J shown in Tables 4 and 5 in which a gas group A of NH₃ and H₂ and a gas group B of TiCl₄, AlCl₃, NH₃, N₂, C₂H₄, and H₂ were used and in each gas supply method, a reaction gas composition (% by volume with respect to the total amount of the gas group A and the gas group B) included a gas group A of NH₃: 1.5% to 3.0% and H₂: 50% to 75% and a gas group B of TiCl₄: 0.1% to 0.15%, AlCl₃: 0.3% to 0.5%, N₂: 0% to 2%, C₂H₄: 0% to 0.05%, and H₂: the remainder, a reaction atmosphere pressure was 2 kPa to 5 kPa, a reaction atmosphere temperature was 700°C to 900°C, a supply period was 1 second to 5 seconds, a gas supply time per one period was 0.15 seconds to 0.25 seconds, and a phase difference between gas supply A and gas supply B was 0.10 seconds to 0.20 seconds, through a thermal CVD method for a predetermined time.

In addition, regarding the present invention coated tools 11 to 13, upper layers shown in Table 6 were formed under the forming conditions shown in Table 3.

In addition, for the purpose of comparison, lower layers shown in Table 6 were formed on the surfaces of the tool bodies A to D under the forming conditions shown in Table 3, and like the present invention coated tools 1 to 13, hard coating layers including at least a layer of a complex nitride or complex carbonitride of Ti and Al were deposited thereon to have target layer thicknesses (µm) shown in Fig. 7 under the conditions shown in Tables 3, 4, and 5.

In addition, like the present invention coated tools 11 to 13, upper layers shown in Table 6 were formed in the comparative coated tools 11 to 13 under the forming conditions shown in Table 3.

The section of each of constituent layers of the present invention coated tools 1 to 13 and the comparative coated tools 1 to 13 in the direction perpendicular to the tool body was measured using a scanning electron microscope (at a magnification of 5,000x). An average layer thickness was obtained by measuring and averaging the layer thicknesses of five points in an observation visual field. All of the results showed substantially the same average layer thicknesses as the target layer thicknesses shown in Tables 6 and 7.

In addition, regarding the average amount Xave of Al of the TiAlCN layer of the upper layer, a sample, of which the surface was polished, was irradiated with electron beams from the sample surface side, and the average amount Xave of Al was obtained by averaging 10 points of the analytic result of obtained characteristic X-rays, using an electron probe micro-analyzer (EPMA).

In addition, the average amount Yave of C was obtained by secondary ion mass spectrometry (SIMS). Ion beams were emitted toward a range of 70 µm × 70 µm from the sample surface side, and the concentration of components emitted by a sputtering action was measured in a depth direction. The average amount Yave of C represents the average value of the TiAlCN layer in the depth direction. However, the amount of C excludes an unavoidable amount of C, which was included even though gas containing C was not intentionally used as a gas raw material. Specifically, the amount (atomic ratio) of the component C contained in the TiAlCN layer in a case where the amount of supplied C₂H₄ was set to 0 was obtained as the unavoidable amount of C, and a value obtained by subtracting the unavoidable amount of C from the amount (atomic ratio) of the component C contained in the TiAlCN layer obtained in a case where C₂H₄ was intentionally supplied was obtained as Yave.

Regarding the TiCN crystal grains of the lower layer and the TiAlCN crystal grains of the upper layer in the hard coating layer, the crystal orientations of individual crystal grains were analyzed using a field emission scanning electron microscope, the inclined angles of the normal lines of the crystal planes of the individual crystal grains with respect to the normal line of the surface of the tool body were measured, and the difference between the inclined angles of the normal lines of the crystal planes (for example, (hkl) planes) of the individual crystal grains measured for the TiCN crystal grains of the lower layer and the TiAlCN crystal grains of the upper layer, which were adjacent to each other via the interface, with respect to the normal line of the surface of the tool body were obtained. Depending on whether or not the difference was 5 degrees or lower, it is determined whether or not the TiCN crystal grains of the lower layer and the TiAlCN crystal grains of the upper layer, which were adjacent to each other via the interface and measured as described above, correspond to the crystal grains specified in the present invention.

That is, regarding the present invention coated tools 1 to 13 and the comparative article coated tools 1 to 13, a measurement range (2.0 µm × 50 µm) of a polished section of 1.0 µm in the thickness direction of the lower layer from the interface between the upper layer and the lower layer, 1.0 µm in the thickness direction of the upper layer, and 50 µm in the direction parallel to the surface of the tool body was set in the body tube of a field emission scanning electron microscope, an electron beam was emitted toward each of the crystal grains having a cubic crystal lattice, which were present in the measurement range of the polished surface at an incident angle of 70 degrees with respect to the polished surface at an acceleration voltage of 15 kV and an emission current of 1 nA. The inclined angles of the normal lines of the (hkl) planes which were crystal planes of the crystal grains with respect to the normal line of the surface of the tool body were measured for the measurement area of 2.0 × 50 µm using an electron backscatter diffraction imaging device at an interval of 0.1 µm/step. For example, in a case where the inclined angle of the normal line of the (hkl) plane of the TiCN crystal grains of the lower layer with respect to the normal line of the surface of the tool body was referred to as α (degrees) and the inclined angle of the normal line of the (hkl) plane of the TiAlCN crystal grains of the upper layer with respect to the normal line of the surface of the tool body was referred to as β (degrees), whether or not the absolute value (= |α (degrees) - β (degrees)|) of the difference between the inclined angles was 5 degrees or lower was obtained. In a case where the difference between the inclined angles was 5 degrees or lower, the TiCN crystal grains of the lower layer and the TiAlCN crystal grains crystal grains of the upper layer, which were adjacent to each other via the interface and measured as described above, were determined as epitaxially grown crystal grains.

In addition, the number of crystal grains determined as the epitaxially grown crystal grains was obtained as the number per unit length of the interface between the upper layer and the lower layer.

In addition, in the present invention, when the number of crystal grains determined as the epitaxially grown crystal grains is counted, the number of TiCN crystal grains adjacent via the interface is counted as 1, and the number of TiAlCN crystal grains adjacent via the interface is counted as 1.

Furthermore, the area ratio (% by area) of the crystal grains determined as the epitaxially grown crystal grains to the total area of the crystal grains adjacent to each other at the interface between the upper layer and the lower layer was measured.

The obtained values are shown in Tables 6 and 7.

In addition, regarding the present invention coated tools 1 to 13 and the comparative coated tools 1 to 13, the individual crystal grains in the (Ti_{1-x-y}AlₓMe_{y}) (C_{z}N_{1-z}) layer included in the layer of a complex nitride or complex carbonitride, which were present in a range of a length of 10 µm in the direction parallel to the surface of the tool body were observed from the film section side perpendicular to the surface of the tool body using a scanning electron microscope (at a magnification of 5,000x and 20,000x) in the sectional direction as the direction perpendicular to the tool body, the maximum grain widths w in the direction parallel to the surface of the body and the maximum grain lengths 1 in the direction perpendicular to the surface of the body were measured to calculate the aspect ratio a(= l/w) of each of the crystal grains. The average value of the aspect ratios a obtained for the individual crystal grains was calculated as an average aspect ratio A. In addition, the average value of the grain widths w obtained for the individual crystal grains was calculated as an average grain width W. The obtained values are shown in Tables 6 and 7.

**[Table 1]**

| Type | | Mixing composition (mass%) | | | | | |
|---|---|---|---|---|---|---|---|
| | | Co | TiC | TaC | NbC | Cr₃C₂ | WC |
| Tool body | A | 8.0 | 1.5 | - | 3.0 | 0.4 | Remainder |
| | B | 8.5 | - | 1.8 | 0.2 | - | Remainder |
| | C | 7.0 | - | - | - | - | Remainder |

**[Table 2]**

| Type | | Mixing composition (mass%) | | | | | | |
|---|---|---|---|---|---|---|---|---|
| | | Co | Ni | ZrC | NbC | Mo₂C | WC | TiCN |
| Tool body | D | 8 | 5 | 1 | 6 | 6 | 10 | Remainder |

**[Table 3]**

| Constituent layers of hard coating layer | | | Forming conditions (pressure of reaction atmosphere is expressed as kPa and temperature is expressed as °C) | | |
|---|---|---|---|---|---|
| Type | | Formation symbol | Reaction gas composition (% by volume) | Reaction atmosphere | |
| | | | | Pressure | Temperature |
| (Ti₁₋ₓAlₓ) (C_{y}N_{1- y}) layer | TiAlCN | TiAlCN | See Table 4 | See Table 5 | See Table 5 |
| Ti compound layer | TiC | TiC | TiCl₄: 4.2%, CH₄: 8.5%, H₂: remainder | 7 | 900 |
| | TiN | TiN-(1) | TiCl₄: 4.2%_{,} N₂: 30%, H₂: remainder | 20 | 900 |
| | | TiN-(2) | TiCl₄: 4.2%, N₂: 35%, H₂: remainder | 7 | 780 |
| | l-TiCN | I-TiCN | TiCl₄: 2%, CH₃CN: 0.7%, N₂: 10%, H₂: remainder | 7 | 780 |
| | TiCNO | TiCNO | TiCl₄: 2%, CH₃CN: 0.7%, CO₂: 1%, N₂: 10%, H₂: remainder | 7 | 780 |
| Al₂O₃ layer | Al₂O₃ | Al₂O₃ | AlCl₃: 2.2%, CO₂: 5.5%, HCl: 2.2%, H₂S: 0.2%, H₂: remainder | 7 | 800 |

**[Table 4]**

| Formation of hard coating layer | | Forming conditions (reaction gas composition indicates proportion in total amount of gas group A and gas group B) | |
|---|---|---|---|
| Process type | Formation symbol | Reaction gas group A composition (% by volume) | Reaction gas group B composition (% by volume) |
| Present invention film forming process | A | NH₃: 2.5%, H₂: 68%, | TiCl₄: 0.10%, AlCl₃: 0.30%, N₂: 0%, C₂H₄: 0%, H₂ as remainder |
| | B | NH₃: 3.0%, H₂: 56%, | TiCl₄: 0.15%, AlCl₃: 0.35%, N₂: 0%, C₂H₄: 0%, H₂ as remainder |
| | C | NH₃: 2.2%, H₂: 71%, | TiCl₄: 0.14%, AlCl₃: 0.35%, N₂: 2%, C₂H₄: 0.05%, H₂ as remainder |
| | D | NH₃: 1.5%, H₂: 62%, | TiCl₄: 0.11%, AlCl₃: 0.33%, N₂: 1%, C₂H₄: 0%, H₂ as remainder |
| | E | NH₃: 2.8%, H₂: 65%, | TiCl₄: 0.15%, AlCl₃: 0.45%, N₂: 0%, C₂H₄: 0.05%, H₂ as remainder |
| | F | NH₃: 2.0%, H₂: 50%, | TiCl₄: 0.15%, AlCl₃: 0.30%, N₂: 0%, C₂H₄: 0%, H₂ as remainder |
| | G | NH₃: 1.8%, H₂: 59%, | TiCl₄: 0.14%, AlCl₃: 0.42%, N₂: 0%, C₂H₄: 0%, H₂ as remainder |
| | H | NH₃: 2.7%, H₂: 64%, | TiCl₄: 0.14%, AlCl₃: 0.38%, N₂: 2%, C₂H₄: 0%, H₂ as remainder |
| | I | NH₃: 1.9%, H₂: 75%, | TiCl₄: 0.13%, AlCl₃: 0.33%, N₂: 1%, C₂H₄: 0.05%, H₂ as remainder |
| | J | NH₃: 2.5%, H₂: 60%, | TiCl₄: 0.11%, AlCl₃: 0.50%, N₂: 0%, C₂H₄: 0%, H₂ as remainder |
| Comparative film forming process | A' | NH₃: 2.0%, H₂: 57%, | TiCl₄: 0.14%, AlCl₃: 0.33%, N₂: 5%, C₂H₄: 0.1%, H₂ as remainder |
| | B' | NH₃: 4.0%, H₂: 70%, | TiCl₄: 0.10%, AlCl₃: 0.40%, N₂: 2%, C₂H₄: 0%, H₂ as remainder |
| | C' | NH₃: 1.5%, H₂: 78%, | TiCl₄: 0.15%, AlCl₃: 0.38%, N₂: 0%, C₂H₄: 0%, H₂ as remainder |
| | D' | NH₃: 2.1%, H₂: 66%, | TiCl₄: 0.08%, AlCl₃: 0.48%, N₂: 1%, C₂H₄: 0.05%, H₂ as remainder |
| | E' | NH₃: 1.8%, H₂: 54%, | TiCl₄: 0.15%, AlCl₃: 0.20%, N₂: 0%, C₂H₄: 0%, H₂ as remainder |
| | F' | NH₃: 3.0%, H₂: 61%, | TiCl₄: 0.20%, AlCl₃: 0.29%, N₂: 0%, C₂H₄: 0.15%, H₂ as remainder |
| | G' | NH₃: 2.7%, H₂: 45%, | TiCl₄: 0.07%, AlCl₃: 0.56%, N₂: 2%, C₂H₄: 0%, H₂ as remainder |
| | H' | NH₃: 2.6%, H₂: 59%, | TiCl₄: 0.15%, AlCl₃: 0.23%, N₂: 0%, C₂H₄: 0.05%, H₂ as remainder |
| | I' | NH₃: 3.5%, H₂: 42%, | TiCl₄: 0.15%, AlCl₃: 0.30%, N₂: 1%, C₂H₄: 0%, H₂ as remainder |
| | J' | NH₃: 2.3%, H₂: 64%, | TiCl₄: 0.15%, AlCl₃: 0.64%, N₂: 0%, C₂H₄: 0%, H₂ as remainder |

**[Table 5]**

| Formation of hard coating layer | | Forming conditions (pressure of reaction atmosphere is expressed as kPa and temperature is expressed as °C) | | | | | | |
|---|---|---|---|---|---|---|---|---|
| Process type | Formation symbol | Gas group A | | Gas group B | | Phase difference in supply between gas group A and gas group B (sec) | Reaction atmosphere | |
| | | Supply period (sec) | Supply time per one period (sec) | Supply period (sec) | Supply time per one period (sec) | | Pressure | Temperature |
| Present invention film forming process | A | 4 | 0.20 | 4 | 0.20 | 0.10 | 5.0 | 750 |
| | B | 2 | 0.15 | 2 | 0.15 | 0.15 | 3.5 | 800 |
| | C | 3 | 0.20 | 3 | 0.20 | 0.10 | 4.5 | 800 |
| | D | 4 | 0.20 | 4 | 0.20 | 0.20 | 2.0 | 900 |
| | E | 1 | 0.25 | 1 | 0.25 | 0.10 | 3.0 | 750 |
| | F | 4 | 0.20 | 4 | 0.20 | 0.15 | 4.5 | 700 |
| | G | 5 | 0.15 | 5 | 0.15 | 0.15 | 5.0 | 800 |
| | H | 3 | 0.25 | 3 | 0.25 | 0.20 | 4.0 | 850 |
| | I | 2 | 0.20 | 2 | 0.20 | 0.10 | 2.5 | 800 |
| | J | 4 | 0.20 | 4 | 0.20 | 0.20 | 4.0 | 750 |
| Comparative film forming process | A' | - | - | - | - | - | 3.5 | 850 |
| | B' | - | - | - | - | - | 5.0 | 800 |
| | C' | - | - | - | - | - | 6.0 | 950 |
| | D' | - | - | - | - | - | 2.5 | 750 |
| | E' | - | - | - | - | - | 4.0 | 650 |
| | F' | - | - | - | - | - | 4.5 | 800 |
| | G' | - | - | - | - | - | 1.5 | 700 |
| | H' | - | - | - | - | - | 3.0 | 750 |
| | I' | - | - | - | - | - | 5.0 | 900 |
| | J' | - | - | - | - | - | 4.5 | 800 |

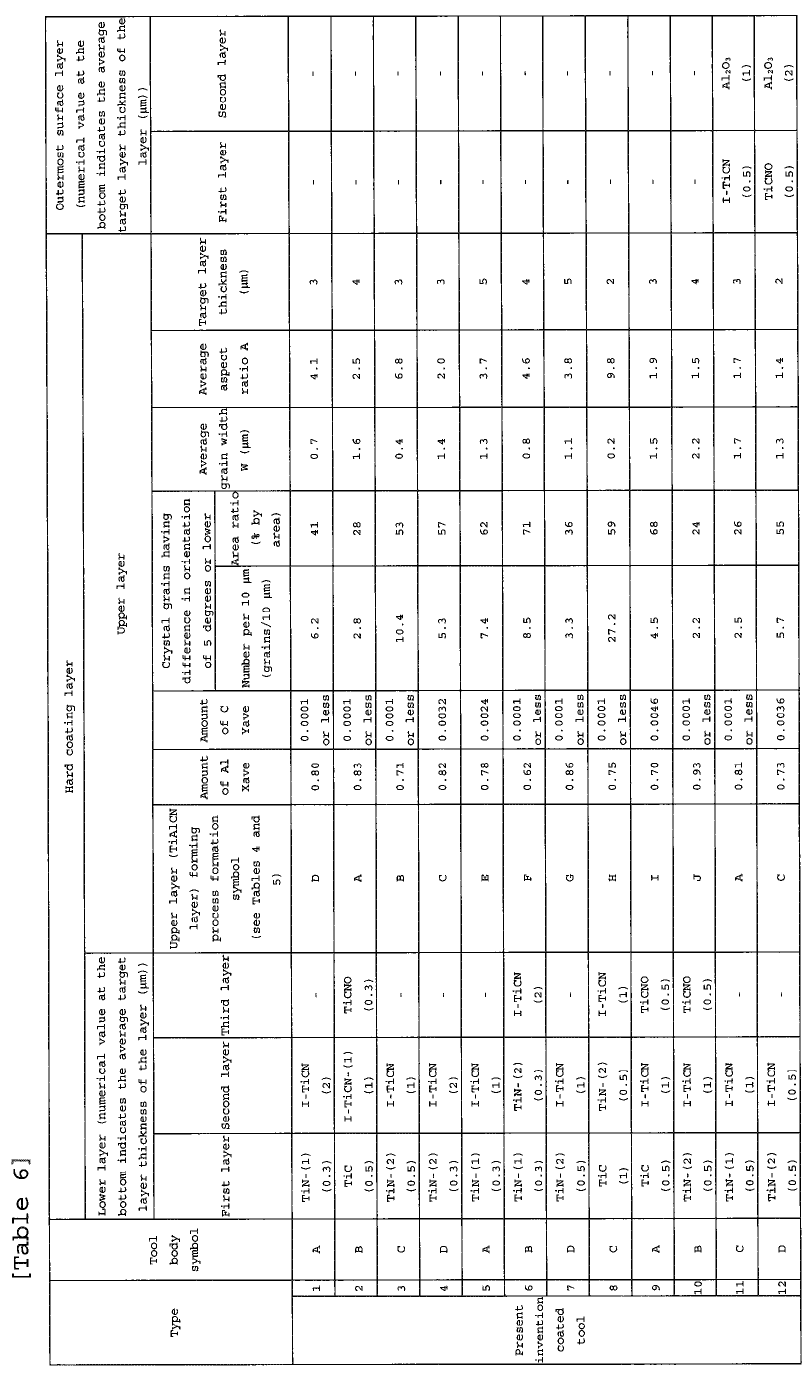

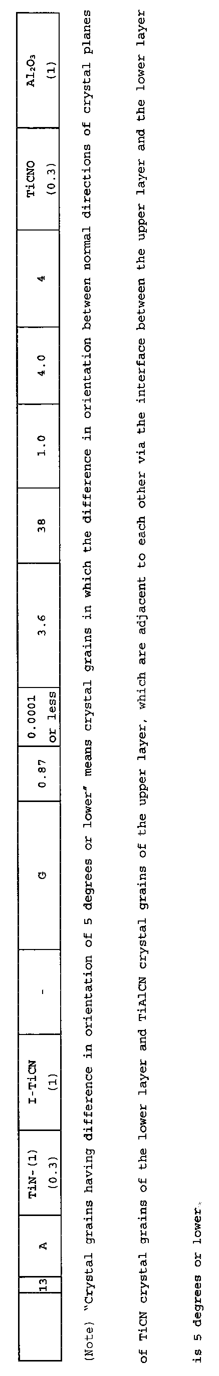

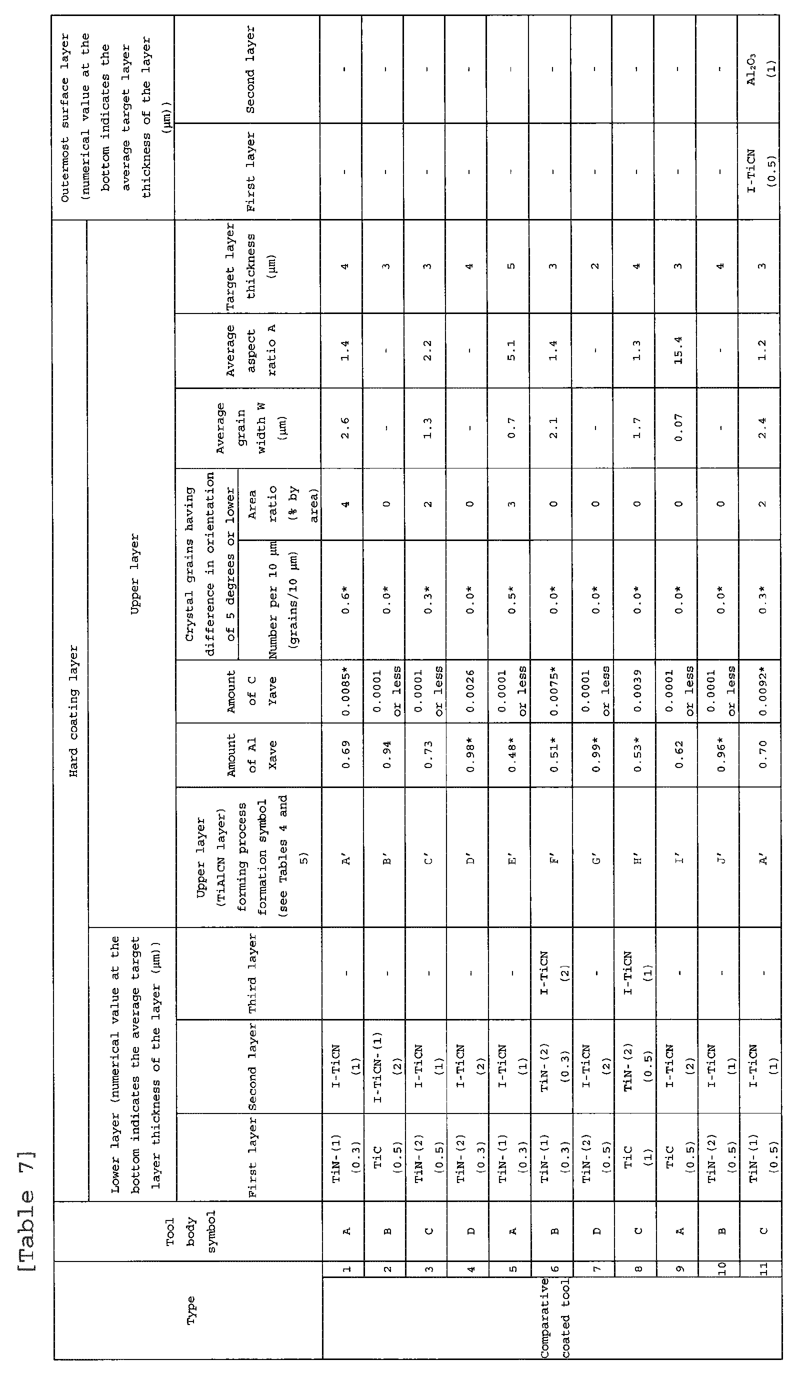

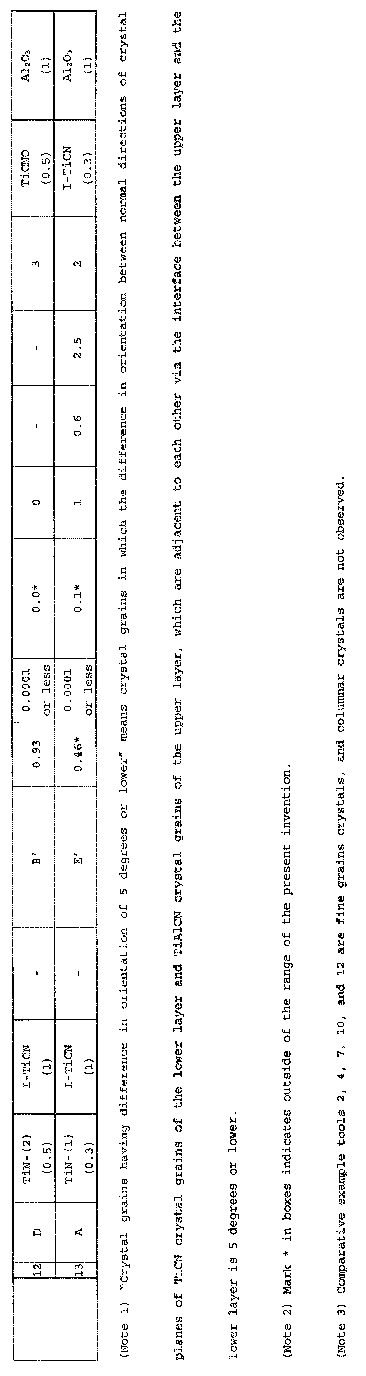

Next, in a state in which each of the various coated tools was clamped to a cutter tip end portion made of tool steel with a cutter diameter of 125 mm by a fixing tool, the present invention coated tools 1 to 13 and the comparative coated tools 1 to 13 were subjected to dry high-speed face milling, which is a type of high-speed intermittent cutting of carbon steel, and a center-cut cutting test, and the flank wear width of a cutting edge was measured. The results are shown in Table 8.

Tool body: tungsten carbide-based cemented carbide, titanium carbonitride-based cermet
Cutting test: dry high-speed face milling, center-cut cutting
Work material: a block material with a width of 100 mm and a length of 400 mm of JIS SCM440
Rotational speed: 968 min⁻¹
Cutting speed: 380 m/min
Depth of cut: 1.5 mm
Feed per edge: 0.1 mm/edge
Cutting time: 8 minutes.

**[Table 8]**

| Type | | Flank wear width (mm) | Type | | Cutting test results (min) |
|---|---|---|---|---|---|
| Present invention coated tool | 1 | 0.16 | Comparative coated tool | 1 | 5.7* |
| | 2 | 0.19 | | 2 | 6.4* |
| | 3 | 0.14 | | 3 | 6.7* |
| | 4 | 0.13 | | 4 | 4.3* |
| | 5 | 0.11 | | 5 | 5.3* |
| | 6 | 0.18 | | 6 | 5.2* |
| | 7 | 0.15 | | 7 | 4.1* |
| | 8 | 0.14 | | 8 | 5.5* |
| | 9 | 0.16 | | 9 | 6.0* |
| | 10 | 0.18 | | 10 | 4.6* |
| | 11 | 0.13 | | 11 | 7.3* |
| | 12 | 0.12 | | 12 | 7.1* |
| | 13 | 0.14 | | 13 | 5.8* |

| | | | | | |
|---|---|---|---|---|---|
| Mark * in boxes of comparative coated tools indicates a cutting time (min) until the end of a service life caused by the occurrence of chipping. | | | | | |

### Example 2

As raw material powders, a WC powder, a TiC powder, a ZrC powder, a TaC powder, an NbC powder, a Cr₃C₂ powder, a TiN powder, and a Co powder, all of which had an average grain size of 1 µm to 3 µm, were prepared, and the raw material powders were mixed in mixing compositions shown in Table 9. Wax was further added thereto, and the mixture was blended in acetone by a ball mill for 24 hours and was decompressed and dried. Thereafter, the resultant was press-formed into compacts having predetermined shapes at a pressure of 98 MPa, and the compacts were sintered in a vacuum at 5 Pa under the condition that the compacts were held at a predetermined temperature in a range of 1370°C to 1470°C for one hour. After the sintering, each of tool bodies E to G made of WC-based cemented carbide with insert shapes according to ISO standard CNMG120412 was produced by performing honing with R: 0.07 mm on a cutting edge portion.

In addition, as raw material powders, a TiCN (TiC/TiN = 50/50 in terms of mass ratio) powder, an NbC powder, a WC powder, a Co powder, and an Ni powder, all of which had an average grain size of 0.5 µm to 2 µm, were prepared, and the raw material powders were mixed in mixing compositions shown in Table 10, were subjected to wet mixing by a ball mill for 24 hours, and were dried. Thereafter, the resultant was press-formed into a compact at a pressure of 98 MPa, and the compact was sintered in a nitrogen atmosphere at 1.3 kPa under the condition that the compact was held at a temperature of 1500°C for one hour. After the sintering, a tool body H made of TiCN-based cermet with an insert shape according to ISO standard CNMG120412 was produced by performing honing with R: 0.09 mm on a cutting edge portion.

Next, present invention coated tools 14 to 26 shown in Table 11 were produced by first forming lower layers shown in Table 11 on the surfaces of the tool bodies E to G and the tool body H using a chemical vapor deposition apparatus under the conditions shown in Tables 3, 4, and 5 in the same method as that in Example 1, and subsequently depositing (Ti₁₋ₓAlₓ) (C_{y}N_{1-y}) layers thereon.

In addition, an upper layer shown in Table 11 was formed in the present invention coated tools 20 to 26 under the forming conditions shown in Table 3.

In addition, for the purpose of comparison, comparative coated tools 14 to 26 shown in Table 12 were produced by depositing hard coating layers on the surfaces of the same cutting tool bodies E to G and the tool body H to have target layer thicknesses shown in Table 12 under the conditions shown in Tables 3, 4, and 5 using a typical chemical vapor deposition apparatus, like the present invention coated tools.

In addition, like the present invention coated tools 20 to 26, an upper layer shown in Table 12 was formed in the comparative coated tools 20 to 26 under the forming conditions shown in Table 3.

The section of each of constituent layers of the present invention coated tools 14 to 26 and the comparative coated tools 14 to 26 was measured using a scanning electron microscope (at a magnification of 5,000x). An average layer thickness was obtained by measuring and averaging the layer thicknesses of five points in an observation visual field. All of the results showed substantially the same average layer thicknesses as the target layer thicknesses shown in Tables 11 and 12.

The average amount Xave of Al and the average amount Yave of C of the TiAlCN layer of the upper layer were obtained using an electron probe micro-analyzer (EPMA) as in Example 1.

In addition, regarding the TiCN crystal grains of the lower layer and the TiAlCN crystal grains crystal grains of the upper layer, which were adjacent to each other via the interface, using a field emission scanning electron microscope, the inclined angle α (degrees) of the normal line of the (hkl) plane of the TiCN crystal grains of the lower layer with respect to the normal line of the surface of the tool body, the inclined angle β (degrees) of the normal line of the (hkl) plane of the TiAlCN crystal grains of the upper layer with respect to the normal line of the surface of the tool body, and the absolute value (= |α (degrees) - β (degrees)|) of the difference between the inclined angles were obtained. The number of TiCN crystal grains of the lower layer and the number of TiAlCN crystal grains of the upper layer, in which the value was 5 degrees or lower, were counted, and the number per unit length of the interface between the upper layer and the lower layer was obtained.

Furthermore, the area ratio (% by area) of the TiCN crystal grains of the lower layer and the TiAlCN crystal grains of the upper layer which satisfy |α (degrees) - β (degrees)| ≤ 5 (degrees) to the total area of the crystal grains adjacent to each other at the interface between the upper layer and the lower layer was obtained.

In addition, the average grain width W and the average aspect ratio A of the crystal grains were obtained as in Example 1.

The obtained values are shown in Tables 11 and 12.

**[Table 9]**

| Type | | Mixing composition (mass%) | | | | | | | |
|---|---|---|---|---|---|---|---|---|---|
| | | Co | TiC | ZrC | TaC | NbC | Cr₃C₂ | TiN | WC |
| Tool body | E | 6.5 | - | 1.5 | - | 2.9 | 0.1 | 1.5 | Remainder |
| | F | 7.6 | 2.6 | - | 4.0 | 0.5 | - | 1.1 | Remainder |
| | G | 6.0 | - | - | - | - | - | - | Remainder |

**[Table 10]**

| Type | | Mixing composition (mass%) | | | | |
|---|---|---|---|---|---|---|
| | | Co | Ni | NbC | WC | TiCN |
| Tool body | H | 11 | 4 | 6 | 15 | Remainder |

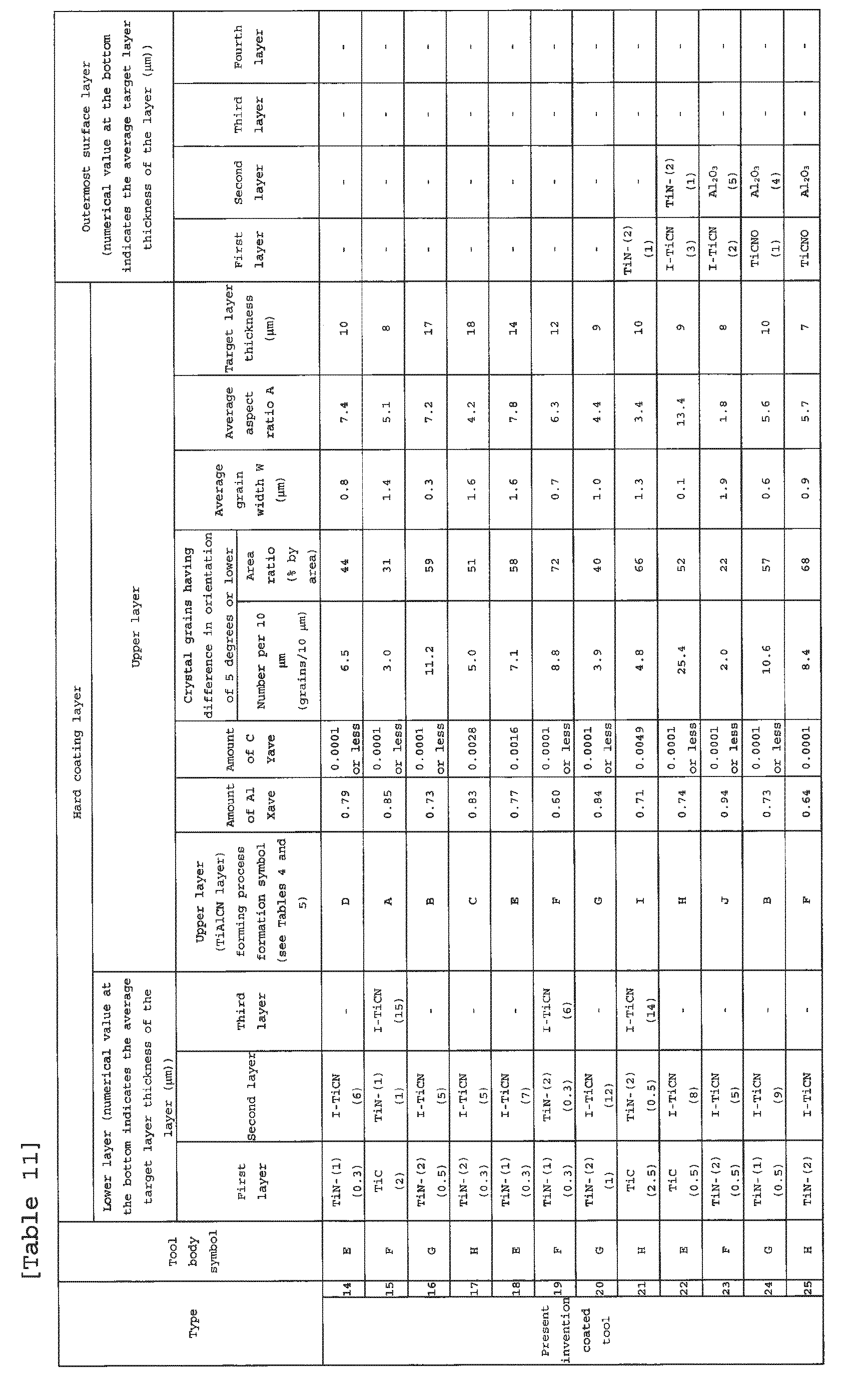

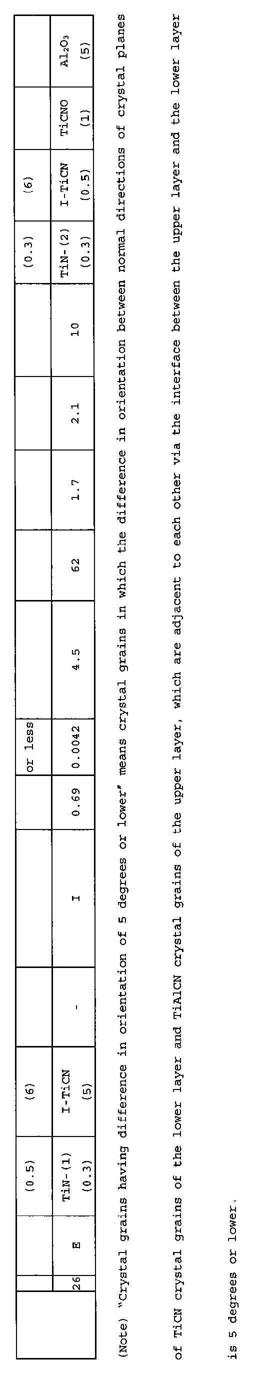

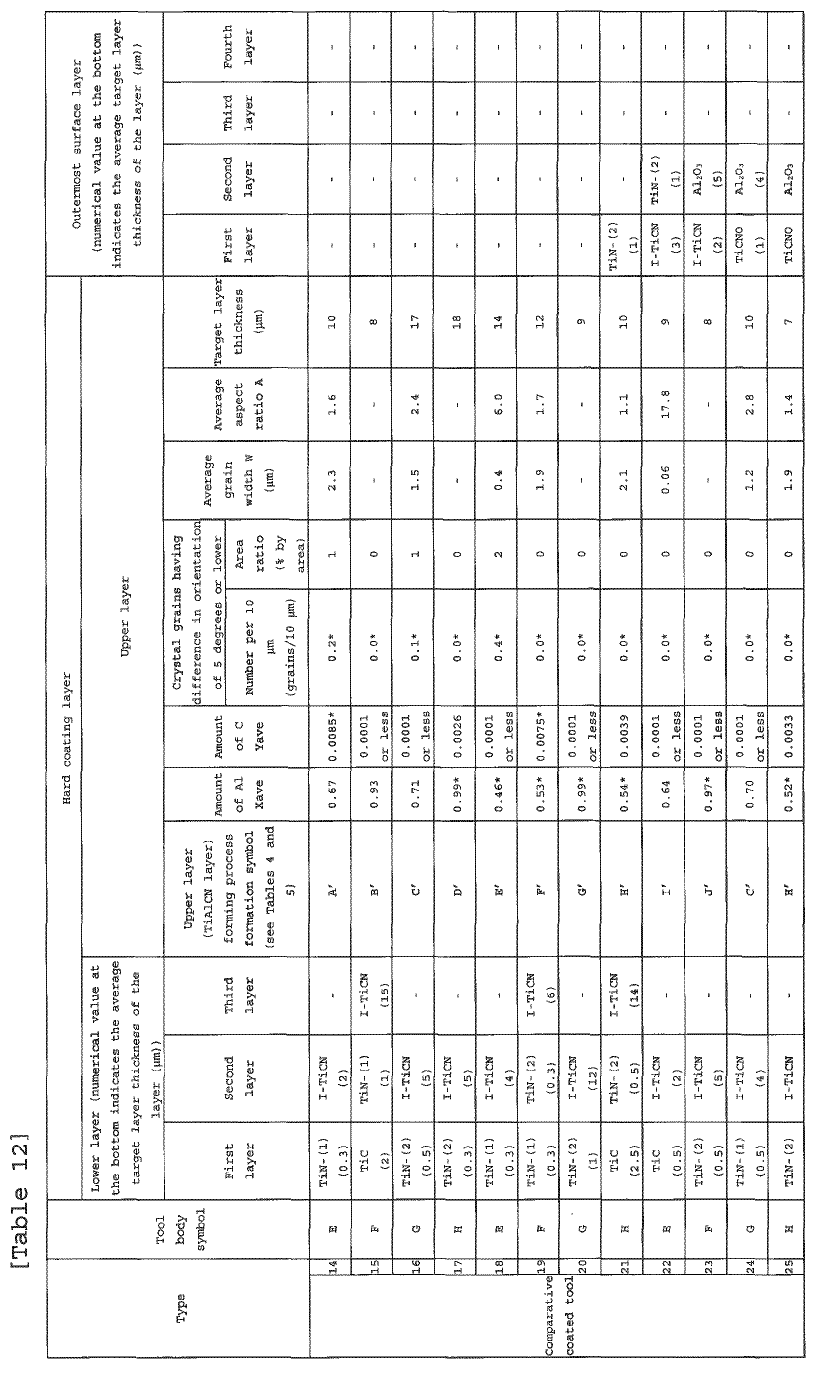

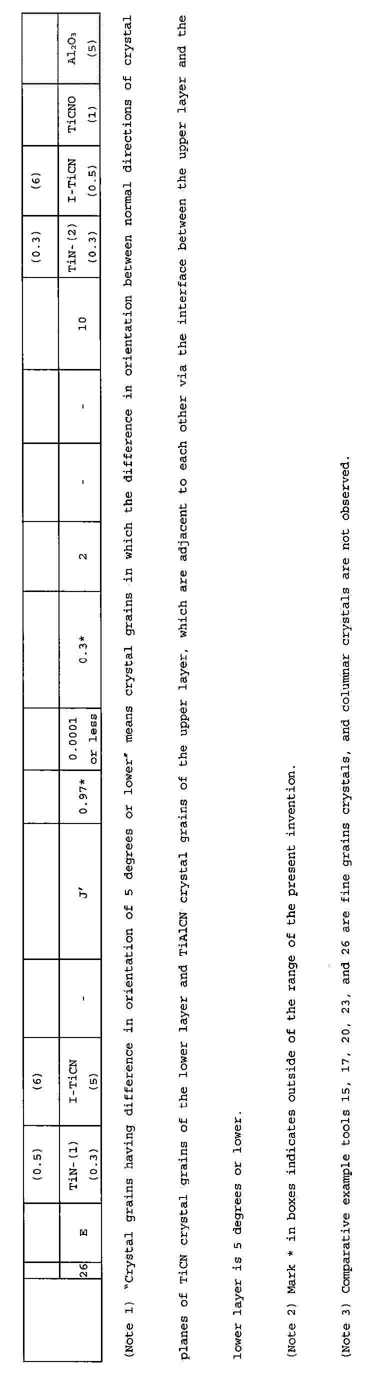

Next, in a state in which each of the various coated tools was screwed to a tip end portion of an insert holder made of tool steel by a fixing tool, the present invention coated tools 14 to 26 and the comparative coated tools 14 to 26 were subjected to a dry high-speed intermittent cutting test for carbon steel, and a wet high-speed intermittent cutting test for cast iron, which will be described below, and the flank wear width of a cutting edge was measured in either case.
Cutting conditions 1:
   Work material: a round bar with four longitudinal grooves formed at equal intervals in the longitudinal direction of JIS S45C
   Cutting speed: 380 m/min
   Depth of cut: 1.5 mm
   Feed: 0.25 mm/rev
   Cutting time: 5 minutes,
   (a typical cutting speed is 220 m/min)
Cutting conditions 2:
   Work material: a round bar with four longitudinal grooves formed at equal intervals in the longitudinal direction of JIS FCD700
   Cutting speed: 320 m/min
   Depth of cut: 1.5 mm
   Feed: 0.1 mm/rev
   Cutting time: 5 minutes,
   (a typical cutting speed is 200 m/min)

The results of the cutting test are shown in Table 13.

**[Table 13]**

| Type | | Flank wear width (mm) | | Type | | Cutting test results (min) | |
|---|---|---|---|---|---|---|---|
| | | Cutting conditions 1 | Cutting conditions 2 | | | Cutting conditions 1 | Cutting conditions 2 |
| Present invention coated tool | 14 | 0.13 | 0.15 | Comparative coated tool | 14 | 3.5* | 3.1* |
| | 15 | 0.15 | 0.17 | | 15 | 4.0* | 3.5* |
| | 16 | 0.14 | 0.15 | | 16 | 4.2* | 3.7* |
| | 17 | 0.13 | 0.14 | | 17 | 2.5* | 1.9* |
| | 18 | 0.10 | 0.11 | | 18 | 3.1* | 2.6* |
| | 19 | 0.19 | 0.18 | | 19 | 3.0* | 2.4* |
| | 20 | 0.15 | 0.14 | | 20 | 2.3* | 1.8* |
| | 21 | 0.18 | 0.19 | | 21 | 3.3* | 2.8* |
| | 22 | 0.11 | 0.12 | | 22 | 3.8* | 3.4* |
| | 23 | 0.16 | 0.14 | | 23 | 2.7* | 2.1* |
| | 24 | 0.14 | 0.13 | | 24 | 4.7* | 4.2* |
| | 25 | 0.15 | 0.13 | | 25 | 4.5* | 3.9* |
| | 26 | 0.13 | 0.11 | | 26 | 3.8* | 3.3* |

| | | | | | | | |
|---|---|---|---|---|---|---|---|
| Mark * in boxes of comparative coated tools indicates a cutting time (min) until the end of a service life caused by the occurrence of chipping. | | | | | | | |

### Example 3

As raw material powders, a cBN powder, a TiN powder, a TiCN powder, a TiC powder, an Al powder, and an Al₂O₃ powder, all of which had an average grain size of 0.5 µm to 4 µm, were prepared, and the raw material powders were mixed in mixing compositions shown in Table 14. The mixture was subjected to wet mixing by a ball mill for 80 hours and was dried. Thereafter, the resultant was press-formed into compacts having dimensions with a diameter of 50 mm and a thickness of 1.5 mm at a pressure of 120 MPa, and the compacts were then sintered in a vacuum at a pressure of 1 Pa under the condition that the compacts were held at a predetermined temperature in a range of 900°C to 1300°C for 60 minutes, thereby producing cutting edge preliminary sintered bodies. In a state in which the preliminary sintered body was superimposed on a support piece made of WC-based cemented carbide, which was additionally prepared to contain Co: 8 mass% and WC: the remainder and have dimensions with a diameter of 50 mm and a thickness of 2 mm, the resultant was loaded in a typical ultrahigh-pressure sintering apparatus, and was subjected to ultrahigh-pressure sintering under typical conditions including a pressure of 4 GPa and a holding time of 0.8 hours at a predetermined temperature in a range of 1200°C to 1400°C. After the sintering, upper and lower surfaces were polished using a diamond grinding wheel, and were split into predetermined dimensions by a wire electric discharge machining apparatus. Furthermore, the resultant was brazed to a brazing portion (corner portion) of an insert body made of WC-based cemented carbide having a composition including Co: 5 mass%, TaC: 5 mass%, and WC: the remainder and a shape (a 80° rhombic shape with a thickness of 4.76 mm and an inscribed circle diameter of 12.7 mm) according to JIS standard CNGA120412 using a brazing filler metal made of a Ti-Zr-Cu alloy having a composition including Zr: 37.5%, Cu: 25%, and Ti: the remainder in terms of mass%, and the outer circumference thereof was machined into predetermined dimensions. Thereafter, each of tool bodies a and b with an insert shape according to ISO standard CNGA120412 was produced by performing honing with a width of 0.13 mm and an angle of 25° on a cutting edge portion and performing finish polishing on the resultant.

**[Table 14]**

| Type | | Mixing composition (mass%) | | | | |
|---|---|---|---|---|---|---|
| | | TiN | TiC | Al | Al₂O₃ | cBN |
| Tool body | a | 50 | - | 5 | 3 | Remainder |
| | b | - | 50 | 4 | 3 | Remainder |

Next, present invention coated tools 27 to 32 shown in Table 15 were produced by first forming lower layers shown in Table 15 on the surfaces of the tool bodies a and b using a typical chemical vapor deposition apparatus under the conditions shown in Tables 3, 4, and 5 in the same methods as those in Examples 1 and 2, and subsequently depositing hard coating layers including (Ti₁₋ₓAlₓ) (C_{y}N_{1-y}) layers thereon to have target layer thicknesses.

In addition, a lower layer and an upper layer shown in Table 15 were formed in the present invention coated tools 30 to 32 under the forming conditions shown in Table 3.

In addition, for the purpose of comparison, comparative exemplary coated tools 27 to 32 shown in Table 16 were produced by depositing hard coating layers on the surfaces of the same cutting tool bodies a and b to have target layer thicknesses shown in Table 16 under the conditions shown in Tables 3, 4, and 5 using a typical chemical vapor deposition apparatus, like the present invention coated tools.

The sections of the present invention coated tools 27 to 32 and the comparative exemplary coated tools 27 to 32 were measured using a scanning electron microscope, and an average layer thickness was obtained by measuring and averaging the layer thicknesses of five points in an observation visual field.

The average amount Xave of Al and the average amount Yave of C of the TiAlCN layer of the upper layer were obtained using an electron probe micro-analyzer (EPMA) as in Example 1.

In addition, regarding the TiCN crystal grains of the lower layer and the TiAlCN crystal grains crystal grains of the upper layer, which were adjacent to each other via the interface, using a field emission scanning electron microscope, the inclined angle α (degrees) of the normal line of the (hkl) plane of the TiCN crystal grains of the lower layer with respect to the normal line of the surface of the tool body, the inclined angle β (degrees) of the normal line of the (hkl) plane of the TiAlCN crystal grains of the upper layer with respect to the normal line of the surface of the tool body, and the absolute value (= |α (degrees) - β (degrees)|) of the difference between the inclined angles were obtained. The number of TiCN crystal grains of the lower layer and the number of TiAlCN crystal grains of the upper layer, in which the value was 5 degrees or lower, were counted, and the number per unit length of the interface between the upper layer and the lower layer was obtained.

Furthermore, the area ratio (% by area) of the TiCN crystal grains of the lower layer and the TiAlCN crystal grains of the upper layer which satisfy |α (degrees) - β (degrees) | ≤ 5 (degrees) to the total area of the crystal grains adjacent to each other at the interface between the upper layer and the lower layer was obtained.

In addition, the average grain width W and the average aspect ratio A of the crystal grains were obtained as in Example 1.

The obtained values are shown in Tables 15 and 16.

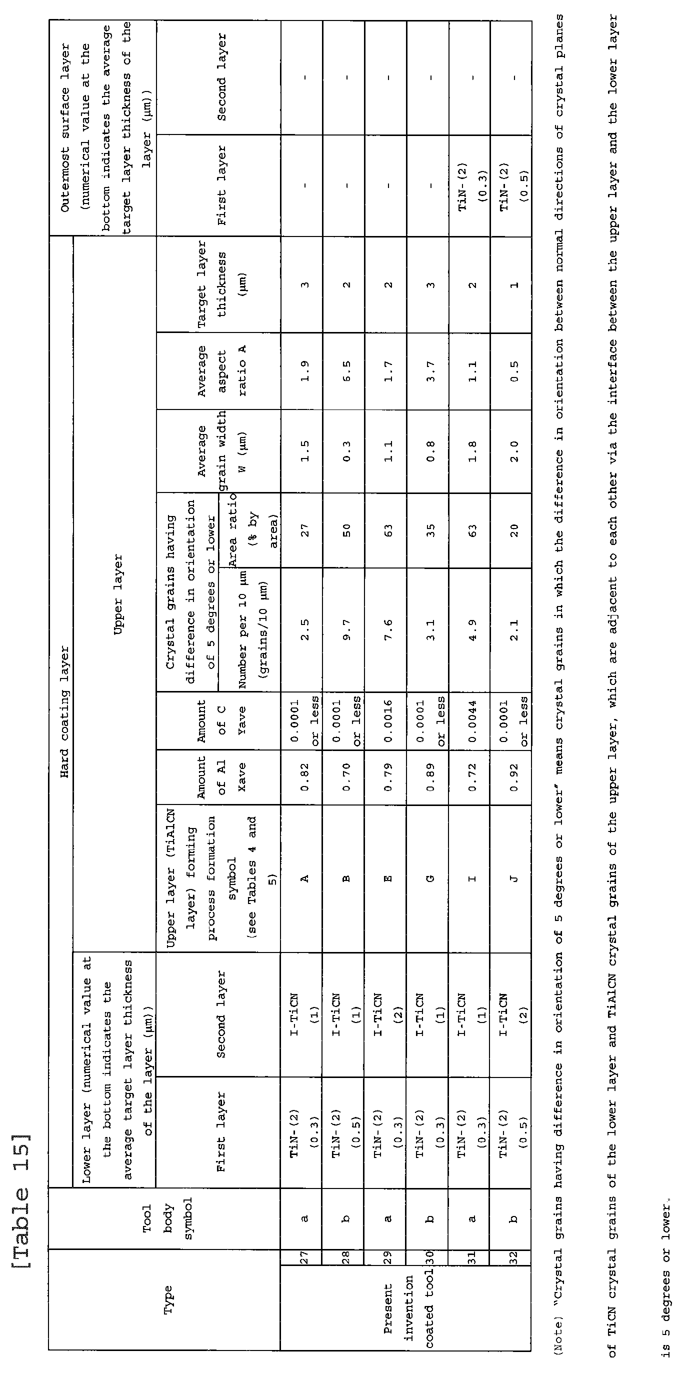

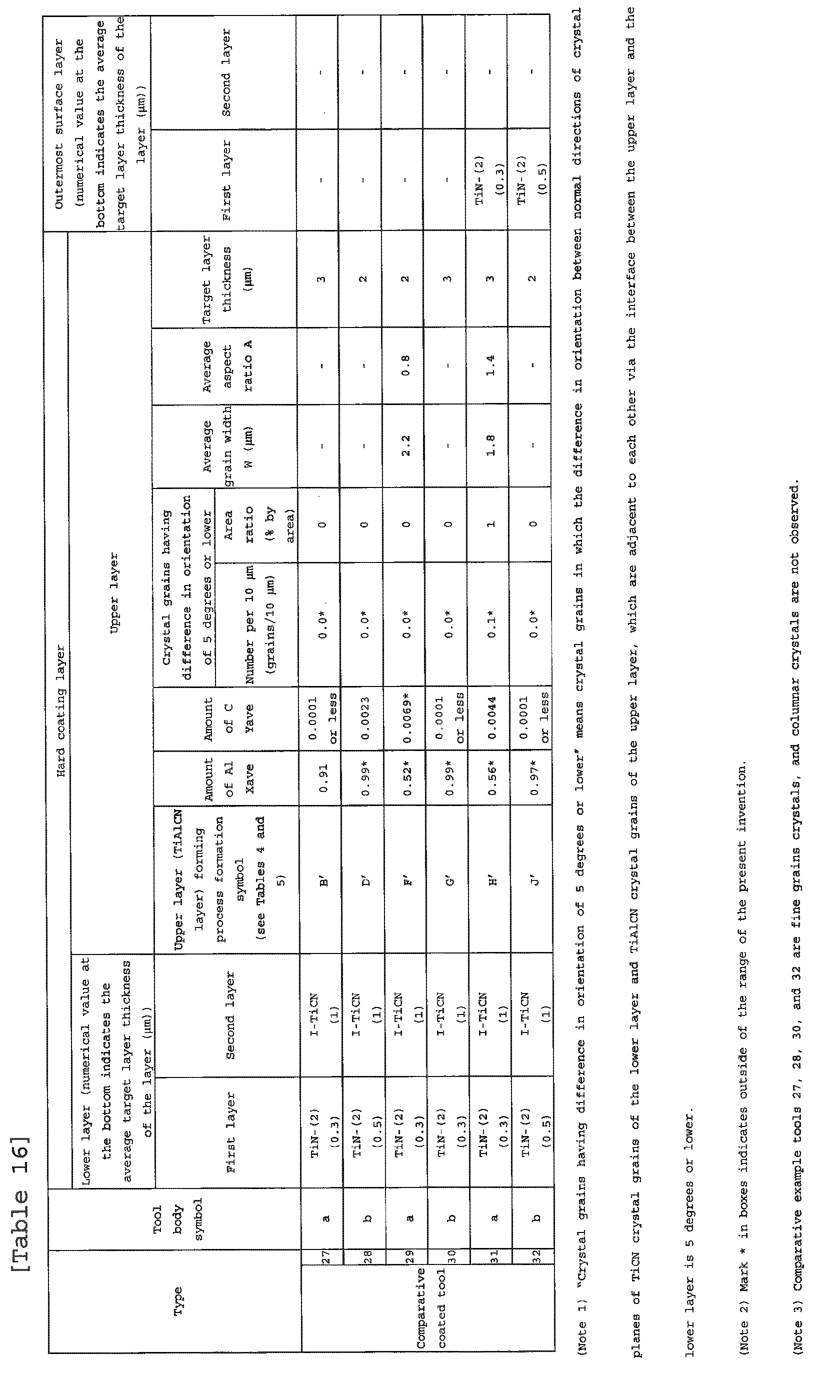

Next, in a state in which each of the various coated tools was screwed to a tip end portion of an insert holder made of tool steel by a fixing tool, the present invention coated tools 27 to 32 and the comparative example coated tools 27 to 32 were subjected to a dry high-speed intermittent cutting work test for carburized alloy steel, which will be described below, and the flank wear width of a cutting edge was measured.
Work material: a round bar with four longitudinal grooves formed at equal intervals in the longitudinal direction of JIS SCr420 (hardness: HRC62)
Cutting speed: 255 m/min
Depth of cut: 0.12 mm
Feed: 0.1 mm/rev
Cutting time: 4 minutes

The results of the cutting test are shown in Table 17.

**[Table 17]**

| Type | | Flank wear width (mm) | Type | | Cutting test results (min) |
|---|---|---|---|---|---|
| Present invention coated tool | 27 | 0.12 | Comparative coated tool | 27 | 3.2* |
| | 28 | 0.11 | | 28 | 2.0* |
| | 29 | 0.08 | | 29 | 2.7* |
| | 30 | 0.10 | | 30 | 2.1* |
| | 31 | 0.07 | | 31 | 2.9* |
| | 32 | 0.10 | | 32 | 2.3* |

| | | | | | |
|---|---|---|---|---|---|
| Mark * in boxes of comparative coated tools indicates a cutting time (min) until the end of a service life caused by the occurrence of chipping. | | | | | |

From the results shown in Tables 6 to 8, 11 to 13, and 15 to 17, regarding the present invention coated tools 1 to 32, the TiCN crystal grains of the lower layer and the TiAlCN crystal grains of the upper layer, which are adjacent to each other via the interface, are epitaxially grown, and thus the adhesion density at the interface is improved. Accordingly, even in a case of being used for high-speed intermittent heavy cutting conditions in which high-temperature heat is generated and high intermittent and impact loads are exerted on a cutting edge, the hard coating layer achieves excellent chipping resistance and peeling resistance, and thus exhibits excellent cutting performance during long-term use.

Contrary to this, it is apparent that regarding the comparative article coated tools 1 to 32, chipping and peeling had occurred in the hard coating layer during high-speed intermittent heavy cutting, and thus the end of the service life thereof is reached within a short time.

### Industrial Applicability

In the coated tools of the present invention, the occurrence of chipping and peeling in the hard coating layer is suppressed during continuous cutting or intermittent cutting of various steels, cast iron, and the like under typical conditions, and even under severe cutting conditions such as high-speed intermittent heavy cutting in which high intermittent and impact loads are exerted on a cutting edge, and thus excellent cutting performance is exhibited during long-term use, thereby sufficiently satisfying an improvement in performance of a cutting device, power saving and energy saving during cutting, and a further reduction in costs.

## Claims

1. A surface-coated cutting tool in which a hard coating layer constituted by a lower layer and an upper layer is formed on a surface of a tool body made of any of tungsten carbide-based cemented carbide, titanium carbonitride-based cermet, and a cubic boron nitride-based ultrahigh-pressure sintered body, wherein
(a) the lower layer is a Ti compound layer that is formed of one layer or two or more layers of a Ti carbide layer, a Ti nitride layer, a Ti carbonitride layer, a Ti oxycarbide layer, and a Ti oxycarbonitride layer and has a total average layer thickness of 1 µm to 20 µm, and includes a Ti carbonitride compound layer having at least an NaCl type face-centered cubic crystal structure,
(b) the upper layer is a layer of a complex nitride or complex carbonitride of Ti and Al having a single phase crystal structure of NaCl type face-centered cubic crystals or a mixed phase crystal structure of NaCl type face-centered cubic crystals and hexagonal crystals with an average layer thickness of 1 µm to 20 µm,
(c) in a case where the layer of a complex nitride or complex carbonitride of Ti and Al is expressed by the composition formula: (Ti₁₋ₓAlₓ) (C_{y}N_{1-y}), an average amount Xave of Al in a total amount of Ti and Al and an average amount Yave of C in a total amount of C and N (both Xave and Yave are atomic ratios) respectively satisfy 0.60 ≤ Xave ≤ 0.95 and 0 ≤ Yave ≤ 0.005, and
(d) regarding the Ti carbonitride layer having an NaCl type face-centered cubic crystal structure in the lower layer and the layer of a complex nitride or complex carbonitride of Ti and Al having an NaCl type face-centered cubic crystal structure in the upper layer, in a case where crystal orientations of individual crystal grains are analyzed in a longitudinal sectional direction perpendicular to the tool body using an electron backscatter diffraction apparatus and inclined angles of normal lines of crystal planes of the individual crystal grains with respect to a normal line of the surface of the body are measured, crystal grains, which are crystal grains adjacent to each other via an interface between the upper layer and lower layer and have a difference in orientation between a normal direction of an (hkl) plane of the crystal grains having an NaCl type face-centered cubic crystal structure in the lower layer and a normal direction of an (hkl) plane of the crystal grains having an NaCl type face-centered cubic crystal structure in the upper layer of 5 degrees or lower, are present at the interface between the upper layer and the lower layer, and a linear density of the crystal grains is 2 crystal grains/10 µm or more.

2. The surface-coated cutting tool according to claim 1, wherein
regarding the Ti carbonitride layer having an NaCl type face-centered cubic crystal structure in the lower layer and the layer of a complex nitride or complex carbonitride of Ti and Al having an NaCl type face-centered cubic crystal structure in the upper layer, in a case where the crystal orientations of the individual crystal grains are analyzed in the longitudinal sectional direction perpendicular to the tool body using the electron backscatter diffraction apparatus and the inclined angles of the normal lines of the crystal planes of the individual crystal grains with respect to the normal line of the surface of the body are measured, an area ratio of the crystal grains, which are the crystal grains adjacent to each other via the interface between the upper layer and lower layer and have a difference in orientation between the normal direction of the (hkl) plane of the crystal grains having an NaCl type face-centered cubic crystal structure in the lower layer and the normal direction of the (hkl) plane of the crystal grains having an NaCl type face-centered cubic crystal structure in the upper layer of 5 degrees or lower, to a total area of the crystal grains adjacent to each other via the interface between the upper layer and the lower layer is 30% by area or more.

3. The surface-coated cutting tool according to claim 1 or 2, wherein,
regarding the layer of a complex nitride or complex carbonitride of Ti and Al, in a case where the layer is observed in the longitudinal sectional direction, a columnar structure in which the crystal grains of the complex nitride or complex carbonitride of Ti, Al, and Me having an NaCl type face-centered cubic structure in the layer have an average grain width W of 0.1 µm to 2.0 µm and an average aspect ratio A of 2 to 10 is included.

4. The surface-coated cutting tool according to any one of claims 1 to 3, wherein
a surface of the upper layer formed of the layer of a complex nitride or complex carbonitride of Ti and Al having a single phase crystal structure of NaCl type face-centered cubic crystals or a mixed phase crystal structure of NaCl type face-centered cubic crystals and hexagonal crystals with an average layer thickness of 1 µm to 20 µm is further coated with an outermost surface layer which has an average layer thickness of 1 µm to 25 µm and includes at least an Al₂O₃ layer.
